Europäisches Patentamt

European Patent Office

Office européen des brevets

(19)

(11) Numéro de publication : **0 117 808 B2**

(12)

# NOUVEAU FASCICULE DE BREVET EUROPEEN

(45) Date de publication du nouveau fascicule du brevet : **04.09.91 Bulletin 91/36**

(51) Int. Cl.$^5$ : **H01F 7/20**

(21) Numéro de dépôt : **84400324.4**

(22) Date de dépôt : **16.02.84**

(54) **Dispositif de maintien et de fixation de bobines destinées à la réalisation d'un champ magnétique constant et homogène.**

Le dossier contient des informations techniques présentées postérieurement au dépôt de la demande et ne figurant pas dans le présent fascicule.

(30) Priorité : **21.02.83 FR 8302757**

(43) Date de publication de la demande :
**05.09.84 Bulletin 84/36**

(45) Mention de la délivrance du brevet :
**13.08.86 Bulletin 86/33**

(45) Mention de la décision concernant l'opposition :
**04.09.91 Bulletin 91/36**

(84) Etats contractants désignés :
**AT BE CH DE GB IT LI LU NL SE**

(56) Documents cités :
**EP-A- 0 011 335**
**EP-A- 0 021 535**
**EP-A- 0 102 486**
**DE-A- 2 840 178**
**DE-A- 2 921 252**
**FR-A- 2 030 104**
**GB-A- 2 027 208**

(56) Documents cités :
**REVIEW OF SCIENTIFIC INSTRUMENTS, vol. 52, no. 9, septembre 1981, pages 1342-1351, New York, US D.I. HOULT et al.: "Electromagnet for nuclear magnetic resonance imaging"**
**IBM TECHNICAL DISCLOSURE BULLETIN, vol. 18, no. 1, juin 1975, page 188, New York, US G.P. DOUBLE et al.: "Collar to mechanically adjust pole-face parallelism"**
**IEEE TRANSACTIONS ON NUCLEAR SCIENCE, vol. NS-27, no. 3, juin 1980, pages 1232-1238, IEEE, New York, US E.R. ANDREW: "Nuclear magnetic resonance imaging: the multiple sensitive point method"**
**TECHN. MITT. KRUPP WERKSBERICHTE, vol 32, no. 3, 1974, pages 104-105 H. ESCHENAUER et al.: "Über die Entwicklungs- und Fertigungsphase des mechanischen Systems der Magnetfeldsimulationsanlage MFSA II in Ottobrunn"**
**Computertomographie, vol.1, p. 2-10**

(73) Titulaire : **DRUSCH et Cie**
**62 rue Galiéni**
**F-92500 Rueil Malmaison (FR)**

(72) Inventeur : **Grangereau, Jean Auguste Marie**
**45 rue de Chateaufort**
**F-91400 Orsay (FR)**

(74) Mandataire : **Madeuf, René Louis et al**
**Cabinet Madeuf Conseils en Propriété Industrielle 3, Avenue Bugeaud**
**F-75116 Paris (FR)**

**EP 0 117 808 B2**

## Description

Il est absolument nécessaire de realiser un champ magnétique homogène pour obtenir des images correctes en imagerie par résonance magnétique nucléaire (imagerie RMN). Or, si l'on désire obtenir un champ magnétique homogène, on pense immédiatement à bobiner un fil de cuivre sur une sphère et à faire passer un courant électrique dans ce fil. On obtient ainsi un champ magnétique parfaitement homogène au centre de la sphère mais on n'a pas accès depuis l'extérieur; on ne peut donc pas utiliser une sphère, pour obtenir un champ magnétique homogène, dans le cas de l'imagerie RMN.

Lorsque l'on désire avoir accès depuis l'extérieur dans un volume de champ magnétique homogène, on réalise un système composé au minimum de quatre bobines dont la disposition des bobinages est sensée être sensiblement sur une sphère approximative imaginaire créant ainsi au centre du volume délimité par ces quatre bobines un champ magnétique aussi homogène que possible. Ainsi, on réalise une construction très intéressante tant au point de vue du nombre d'ampères/tours nécessaires que de la facilité de réglage des bobines.

Le fait d'inscrire théoriquement ces bobines sur le pourtour d'une sphère approximative imaginaire paraît être simple mais, pour obtenir ce résultat sur un grand volume, il est extrêmement difficile de placer puis de maintenir les bobines car celles-ci, du fait du passage du courant, ont tendance à se dilater et réagissent les unes sur les autres, c'es-à-dire ont tendance à se déplacer les unes par rapport aux autres, ce qui n'est pas admissible. De plus, on est amené à tenir compte de l'environnement qui peut contenir des champs magnétiques parasites, champs magnétiques créés par l'armature d'un bâtiment en béton armé, le passage d'un ou de plusieurs câbles électriques d'alimentation du réseau, l'emplacement plus ou moins lointain de masses magnétiques diverses.

Le document "Review of scientifiv instruments, vol. 52, N° 9, septembre 1981" décrit un dispositif de maintien et de fixation de bobines destinées à la réalisation d'un champ magnétique constant et homogène, constitué par un châssis inférieur amagnétique (en A1) formant banc sur lequel est monte un bâti (voir fig. 3) comportant des éléments, tels des flasques, pour maintenir fermement l'armature contenant le bobinage électrique. Mais, il s'agit de demi-coquilles maintenant deux bobines fixes l'une par rapport à l'autre.

Le document allemand DE-A-2 921 252 décrit un dispositif comportant sensiblement les mêmes caractéristiques que ci-dessus.

La présente invention a donc pour objet de créer un support de maintien et de fixation des bobines contenant les bobinages de façon à les inscrire à peu pres sur une sphère approximative imaginaire tout en aménageant un passage central important et d'empêcher tout déplacement relatif de chaque bobine les unes par rapport aux autres, afin de créer un champ magnétique homogène et constant. Le dispositif de la présente invention est décrit dans la revendication 1.

Conformément à l'invention, le dispositif de maintien et de fixation des bobines, réalisé en matériaux amagnétiques et destiné à la réalisation d'un champ magnétique constant et homogène qui est constitué par un châssis inférieur amagnétique formant banc sur lequel est monté un bâti comportant deux flasques maintenant fermement l'armature contenant l'élément électrique dénomme bobinage électrique de référence placé à l'intérieur de cette armature qui renferme également des canaux pour une circulation de refroidissement par liquide est caractérisé en ce que des bâtis disposés convenablement reposant par leur partie inférieure sur le châssis permettent de poser soit directement, soit par l'intermédiaire de caissons, des bobines contenues dans des armatures de diamètre égal à celui de la première armature ou plus petit, afin que les bobinages électriques soient disposés de telle façon qu'ils s'inscrivent sur le pourtour d'une sphère approximative imaginaire, le réglage des bobinages s'effectuant par l'intermédiaire des armatures au moyen de vérins à vis disposés entre le banc et la partie inférieure de l'armature et de vérins à vis placés entre des ferrures latérales ou d'extrémité solidaires des armatures en prenant comme repère l'armature de la bobine de référence fixée sur le bâti solidaire du châssis, chacun desdits vérins à vis étant ainsi, placé entre deux bobines latérales.

Les vérins à vis sont des organes de maintien à pas différentiel pour permettre un réglage fin de la position des armatures les unes par rapport aux autres afin d'inscrire les bobinages contenus dans ces armatures sur le pourtour de la sphère approximative imaginaire, les ferrures latérales fixées sur l'armature sont diamètralement opposées les unes par rapport aux autres ou réparties régulièrement sur le pourtour de chaque armature.

Une forme de réalisation du dispositif de maintien et de fixation des bobines est représentée, à titre d'exemple, au dessin annexé.

La fig. 1 est une élévation latérale du dispositif de support maintenant quatres armatures contenant les bobines.

La fig. 2 est une vue en perspective générale du dispositif de l'invention.

Les fig. 3 et 4 montrent, à plus grande échelle, en élévation de face et en élévation latérale, des organes de maintien et de réglage des armatures contenant les bobines.

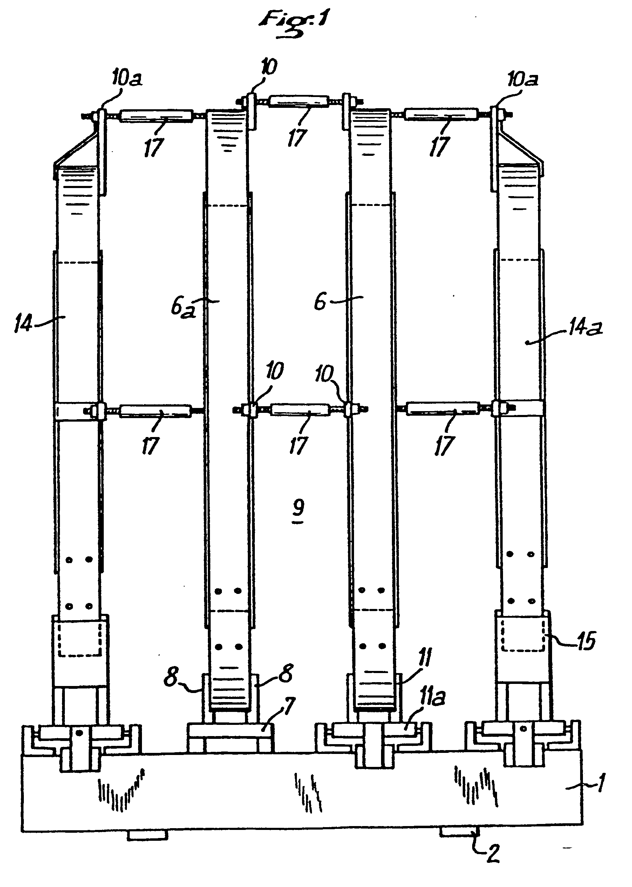

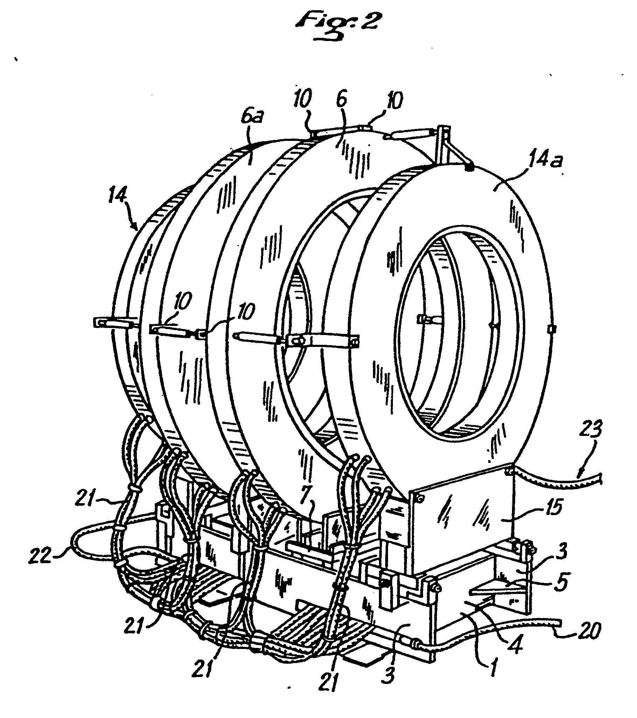

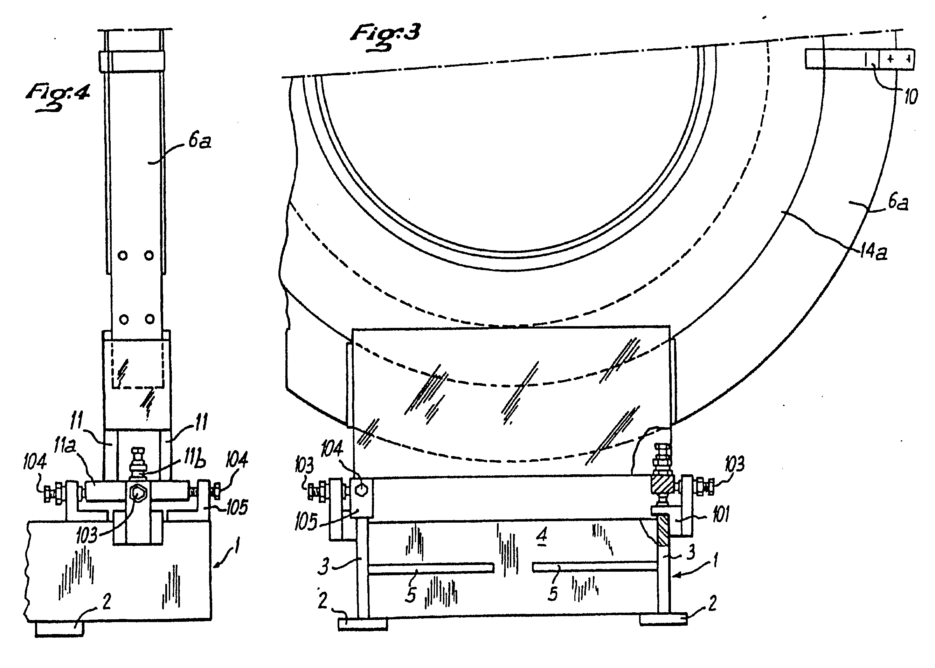

A la fig. 1, on a représenté le châssis inférieur 1 formant banc reposant sur le sol par des pieds 2. Le banc 1 est réalisé par des longerons 3 convenablement entretoisés par des traverses 4 qui sont elles-mêmes maintenus fermement verticales par des équerres 5 judicieusement disposées. Bien entendu le banc 1 est réalisé en matière amagnétique indéformable et supporte d'abord à sa partie supérieure, près de sa zone centrale, un bâti 7 comportant deux flasques verticaux 8 sur lesquels est montée l'armature 6 contenant l'élément électrique appelé ci-après bobinage de référence 9. L'armature 6 renferme également des canaux pour une circulation de refroidissement par liquide, en général de l'eau. Sur l'armature 6 sont fixées des ferrures latérales 10 disposées, dans le cas présent, à 90° les unes des autres.

Une autre armature de grande dimension 6a (voir fig. 3 et 4) est exactement constituée comme la précédente. Elle repose sur le châssis 1 par l'intermédiaire de deux flasques 11 reliés à leur partie inférieure par deux treverses 11a supportées par des vérins verticaux à filetage différentiel 11b sur deux supports 101 sensiblement en T solidaires du banc 1, puis par deux vérins différentiels transversaux 103 supportés par les pièces 101 et par quatre vérins différentiels longitudinaux 104 supportés par quatre équerres 105 solidaires du dessus du banc 1. Ainsi on peut régler aisément, à l'aide des vérins verticaux 11b et horizontaux 103, 104, la position de l'armature 6a.

Des armatures d'extrémité 14 et 14a, qui sont de plus petit diamètre, reposent sur le châssis 1 par l'intermédiaire d'un caisson 15 dont la position est réglée par un même jeu de vérins de réglage verticaux et horizontaux que ci-dessus pour l'armature 6a. De plus, et dans le cas présent, à trois endroits différents sont fixées sur les armatures 6, 6a, 14 et 14a des ferrures latérales 10 ou ferrures d'extrémité 10a permettant la mise en place des vérins à vis 17 qui sont des organes de maintien à pas différentiel.

Lorsque l'ensemble est ainsi monté, c'est-à-dire que l'armature 6 de la bobine de référence est fixée parfaitement verticalement par rapport au banc 1 et d'une manière sûre et que les armatures 6a, 14 et 14a ont été placées géométriquement aussi bien que possible par rapport à l'armature 6, on détermine au moyen de mesures magnétiques très précises les réglages à faire sur les positions des armatures 6a, 14 et 14a et l'on effectue ceux-ci au moyen des vérins IIb, 103, 104 et 17, avec une grande précision, de façon à obtenir le champ magnétique homogène cherché.

Dans le cas présent, les armatures 6, 6a, 14 et 14a sont maintenues en cinq points, mais il est possible également de maintenir les armatures en trois, quatre, six points ou plus en disposant un autre nombre d'éléments du type des vérins 17.

Cependant, la disposition des quatre armatures parallèles (voir fig. 1 et 2) de diamètres interne et externe différents permet d'inscrire assez facilement les bobinages sur la surface d'un volume approximatif du genre sphérique.

On voit à la fig. 2, à partir d'un conduit d'alimentation 20, les différents conduits 21 qui alimentent en eau de refroidissement les canaux de circulation placés à l'intérieur des armatures 6, 6a, 14, 14a. Cette eau de refroidissement repart par un conduit 22. 23 est le câble d'alimentation des bobines.

Bien que la disposition à quatre bobines permette d'obtenir un champ magnétique très homogène, il est possible, dans certains cas, de disposer plus de quatre bobines afin d'augmenter l'homogénité du champ magnétique. Dans ce cas, à partir de la bobine de référence qui est ici la bobine 9, on règle la position des différentes bobines au moyen de vérins à vis et de maintien à pas différentiel 17, comme expliqué ci-dessus.

Comme il a déjà été indiqué, le châssis principal ou banc 1 est realisé en matériau amagnétique indéformable et il est capable de supporter le poids des quatre armatures 6, 6a, 14, 14a des bobines ainsi que les efforts d'origine magnétique qui s'exercent entre les bobines du fait de leur action mutuelle.

Le banc 1 supporte également des variations de dimensions dues aux variations de la température ambiante, mais, du fait de la conception sphérique des éléments de liaison entre les différentes bobines, les diverses causes de déformation agissent seulement au second ordre.

Ceci permet donc de certifier que la carte de champ magnétique à l'intérieur des bobines n'est altérée qu'au deuxième degré par ces différentes causes, sans risque de provoquer des perturbations lors de la prise d'images RMN.

De préférence, l'armature et le bobinage électrique sont solidarisés par moulage.

## Revendications

1. Dispositif de maintien et de fixation de bobines destinés à la réalisation d'un champ magnétique constant et homogène, qui est constitué par un châssis inférieur amagnétique (1) formant banc sur lequel est monté un bâti (7) comportant deux flasques (8) maintenant fermement l'armature (6) contenant l'élément électrique dénommé bobinage électrique (9) de référence placé à l'intérieur de cette armature (6) qui renferme également des conduits pour une circulation de refroidissement par liquide, caractérisé en ce que:

a) des bâtis (11) reposant par leur partie inférieure sur le châssis (1) permettent de poser soit directement soit par l'intermédiaire de caissons (15) des bobines contenues dans des armatures (6a, 14, 14a) de diamètre égal à celui de la première armature (6) ou plus petit afin que les bobinages électriques soient disposés de telle façon qu'ils s'inscrivent sur le pourtour d'une sphère approximative imaginaire, le réglage des bobinages s'effectuant par l'intermédiaire des armatures (6a, 14, 14a) au moyen de vérins à vis (11b, 103, 104) disposés entre le banc et la partie inférieure de chaque armature et de vérins à vis (17) placés entre des ferrures latérales (10) ou d'extrémité (10a) solidaires des armatures (6, 6a, 14, 14a) et réparties sur le pourtour des armatures en prenant comme repère l'armature (6) de la bobine de référence (9) fixée sur le bâti (7) solidaire du châssis (1), chacun desdits vérins à vis (17) étant ainsi placé entre deux bobines voisines,

b) les vérins à vis (11b, 103, 104) et les vérins à vis (17) sont des organes de maintien à pas différentiel pour permettre un réglage fin de la position des armatures (6, 6a, 14, 14a) les unes par rapport aux autres afin d'inscrire les bobinages contenus dans ces armatures sur le pourtour de la sphère approximative imaginaire,

c) finalement, les ferrures latérales (10) fixées sur les armatures (6, 6a, 14, 14a) sont diamétralement opposées les unes par rapport aux autres ou réparties régulièrement sur le pourtour de chaque armature.

2. Dispositif suivant la revendication 1, caractérisé en ce que l'armature et le bobinage électrique sont solidarisés par moulage.

**Patentansprüche**

1. Vorrichtung zur Halterung und Festlegung von Wicklungen zur Erzeugung eines konstanten und homogenen Magnetfeldes, die einen unteren, nicht magnetischen Ständer (1) aufweist, der ein Bett bildet, auf dem ein Gestell (7) mit zwei Flanschen (8) montiert ist, das die Armatur (6) festhält, die das als elektrische Referenzwicklung (9) bezeichnete und im Inneren dieser Armatur (6) angeordnete elektrische Element aufnimmt und ausserdem Leitungen für einen Kühlflüssigkeitsumlauf einschliesst, dadurch gekennzeichnet,

a) dass Gestelle (11), die mit ihrem Unterteil auf dem Ständer (1) ruhen, es erlauben, entweder direkt oder durch Zwischenschaltung von Gehäusen (15) Spulen zu lagern, die in Armaturen (6a, 14, 14a) aufgenommen sind mit einem Durchmesser gleich demjenigen der ersten Armatur (6) oder kleiner, damit die elektrischen Wicklungen in einer solchen Weise angeordnet sind, dass sie sich in den Umriss einer ungefähren imaginären Kugel einschreiben, und dass die Einregulierung der Wicklungen durch Zwischenschaltung der Armaturen (6a, 14, 14a) mittels Schraubwinden (11b, 103, 104) erfolgt, die zwischen dem Bett und dem Unterteil jeder Armatur angreifen und durch Schraubwinden (17) erfolgt, die zwischen seitlichen Beschlägen (10) oder äusseren Beschlägen (10a) angeordnet sind, die mit den Armaturen (6, 6a, 14, 14a) verbunden und über den Umkreis der Armaturen verteilt sind, indem als Massstab die Armatur (6) der Referenzspule (9) genommen wird, die auf dem mit dem Ständer (1) verbundenen Gestell (7) befestigt ist, so dass jede der besagten Schraubwinden (17) zwischen zwei benachbarten Spulen angeordnet ist ;

b) dass die Schraubwinden (11b, 103, 104) und die Schraubwinden (17) Halteorgane mit Differentialschritt sind, um eine Feineinregulierung der Lage der Armaturen (6, 6a, 14, 14a) zueinander zu ermöglichen, um die in diesen Armaturen aufgenommenen Wicklungen in den Umriss der ungefähren imaginären Kugel einzubeschreiben ;

c) und dass die an die Armaturen (6, 6a, 14, 14a) befestigten seitlichen Beschläge (10) diametral einander gegenüberliegen oder gleichmässig über den Umfang jeder Armatur verteilt sind.

2. Vorrichtung nach Anspruch 1, dadurch gekennzeichnet, dass die Armatur und die elektrische Wicklung durch Formung vereint sind.

**Claims**

1. Device for maintaining and fixing coils provided for making a constant and homogeneous magnetic field, which is made by a lower amagnetic body (1) forming a bench on which is mounted a frame (7) comprising two cheeks (8) firmly maintaining the armature (6) containing the electrical element named as reference electric winding (9) mounted within this armature (6) which also encloses ducts for a cooling circulation by liquid, characterized in that :

a) frames (11) bearing by their lower part on the body (1) enable to lay, either directly or through boxes (15), coils contained in armatures (6a, 14, 14a) of a diameter equal to or smaller than that of the first armature (6) in order that the electric windings are placed in such a manner that they are inscribed on the periphery of an imaginary approximative sphere, adjustment of the windings being made via the armatures (6a, 14, 14a) by means of screw jacks (11b, 103, 104) placed between the bench and the lower part of each armature and screw jacks (17) placed between lateral (10) or end (10a) iron fittings rigidly connected to the armatures (6, 6a, 14, 14a) and distributed on the periphery of the armatures by taking as reference the armature (6) of the reference coil (9) fixed on the frame (7) rigidly connected to the body (1), each of said screw jacks (17) being thus positioned between two neighbouring coils,

b) the screw jacks (11b, 103, 104) and the screw jacks (17) are differential pitch maintaining means for enabling a fine adjustment of the position of the armatures (6, 6a, 14, 14a) the one with respect to the other in order to inscribe the windings contained within these armatures on the periphery of the imaginary approximative sphere, c) finally, the lateral iron fittings (10), rigidly connected to the armatures (6, 6a, 14, 14a), are diametrically opposed the one with respect to the other or regularly distributed on the periphery of each armature.

2. Device according to claim 1, characterized in that the armature and the electric winding are rigidly connected by moulding.

Fig.1

*Fig. 2*

Fig.4

Fig.3

EP 0 117 808 B2